# EUROPEAN PATENT APPLICATION

(11) **EP 4 610 591 A1**
(43) Date of publication of application: **03.09.2025**
(21) Application number: 25154240.3
(22) Date of filing: 27.01.2025
(51) Int. Cl.: G01B 5/20, F01D 21/00, G01B 11/24, G01B 11/25

(54) **SYSTEMS AND METHODS FOR ACQUIRING DATA OF AIRCRAFT COMPONENTS**

(30) Priority: 29.02.2024 US 202418592206
(71) Applicant: Chromalloy Gas Turbine LLC, Palm Beach Gardens, Florida 33410 (US)
(72) Inventor: ROMERO, Mauricio, Osmar, Palm Beach Gardens, 33410 (US); CHANG, Freddy, Alexander, Palm Beach Gardens, 33410 (US)
(74) Representative: Abel & Imray LLP

(57) **Abstract**

Techniques for acquiring data from aircraft components (500), such as turbine blades used in jet engines are provided. Specifically designed fixtures (400) with reference points (410) are constructed to hold the blade to be scanned. A 3D scanner (504) is used to acquire positional data of the blade at a high resolution and this data is used to generate a 3D model. The 3D model can be used to validate, for example, that a component of an aircraft has been manufactured as designed.

## Description

### TECHNICAL OVERVIEW

The technology described herein relates to techniques for acquiring data of physical objects - such as those that have been manufactured. More particularly, the technology described herein relates to techniques for acquiring data from aircraft components, such as turbine blades used in jet engines. The data may be acquired at a high resolution and used to generate a virtual 3D model. The 3D model can be used to validate, for example, that a component of an aircraft has been manufactured as designed.

### INTRODUCTION

Manufacturing aircraft components requires a high degree of precision. For example, when a blade used in aircraft engine is manufactured, the tolerance for the location of structural elements - such as a hole or ridge - may be on the order of less than 100 thou. Such precision can be due to the extreme performance in which these components are required to operate. For example, a turbine blade may operate in an environment in which the temperature exceeds the melting point of the material used in the turbine blade. To address such operating environments, turbine blades can be designed to include cooling holes (which operate to facilitate cooling of the blade during operations) and the like to allow the blades to operate with the required level of performance in the given environment. Accordingly, aircraft components are designed in order to ensure proper operation of the component - and the aircraft as a whole.

An issue with manufacturing at this level of precision (e.g., <100 thou) is that it can be difficult to validate (e.g., using geometric dimensioning and tolerancing techniques) that a component has been manufactured as designed. One possible approach is to physically test the component (e.g., stress test the component). In the case of turbine blades, physical testing may also include airflow analysis of the blade to ensure that the cooling holes are functioning properly. However, this type of approach can be time consuming and/or prone to validation errors.

Accordingly, it will be appreciated that new and improved techniques, systems, and processes are continually sought after.

### SUMMARY

In certain example embodiments, a system for generating a three-dimensional scanning process is provided. The scanning process that is generated can then be repeatedly used on each component that is manufactured for a given component type (e.g., each type of turbine blade). The generation of the scanning process includes defining values for parameters in a scanning template, determining a lens volume that is to be used for 3D scanning a component, building a fixture to hold the component during the scanning process, and the like. The scanning template parameters can include acquisition parameters, reference point parameters, polygonization settings, teaching settings, and others. The lens volume can vary depending on the type of data to be acquired to validate the component. Lens volumes may vary between 50mm to 500mm. The fixture is built in order to provide a structure to hold multiple different reference points that are used to assist in generating a 3D mesh based on the obtained 3D measurement data - while also allowing the scanning system to acquire data from specified positions and angles. Once a scanning process has been determined or otherwise generated, it can then be deployed as part of a GD&T process that is used to validate manufactured components. The repeated use of the developed scanning process may be substantially or entirely automated.

This Summary is provided to introduce a selection of concepts that are further described below in the Detailed Description. This Summary is intended neither to identify key features or essential features of the claimed subject matter, nor to be used to limit the scope of the claimed subject matter; rather, this Summary is intended to provide an overview of the subject matter described in this document. Accordingly, it will be appreciated that the above-described features are merely examples, and that other features, aspects, and advantages of the subject matter described herein will become apparent from the following Detailed Description, Figures, and Claims.

### BRIEF DESCRIPTION OF THE DRAWINGS

These and other features and advantages will be better and more completely understood by referring to the following detailed description of example non-limiting illustrative embodiments in conjunction with the drawings of which:
Figure 1 shows an example scanning system, fixture, and component according to certain example embodiments;
Figure 2A is a flow chart of an example process for developing a scanning process for aircraft parts according to certain example embodiments;
Figure 2B is a screen shot of a graphical user interface showing different types of acquisition parameters that may be set for the processing shown in Figure 2A;
Figure 3 is a flow chat of an example process that may be repeatedly used for scanning manufactured aircraft parts according to certain example embodiments;
Figure 4 is a perspective view of a type of fixture that is designed to hold an aircraft part as part of the processes shown in Figures 2A and 3 according to certain example embodiments;
Figure 5 is the perspective view of the fixture from Figure 4 and that also includes a representation of an aircraft part according to certain example embodiments;
Figure 6 is a top-down view of the fixture shown in Figure 4;
Figure 7 is a perspective view of an aircraft part held in another example type of fixture that is designed to hold the aircraft part according to certain example embodiments;
Figure 8 is a top-down view of the aircraft part and fixture shown in Figure 7 according to certain example embodiments;
Figure 9 is a screenshot of a graphical user interface showing a three-dimensional mesh of a blade for a turbine engine held in a fixture according to certain example embodiments;
Figure 10 is another screenshot of a graphical user interface showing a three-dimensional mesh of a blade for a turbine engine held in a fixture according to certain example embodiments;
Figures 11 and 12 are screenshots of different views of a three-dimensional mesh of a cooling hole in the blade shown in Figure 10 according to certain example embodiments; and
Figure 13 shows an example computing device that may be used in some embodiments to implement features described herein.

### DETAILED DESCRIPTION

In the following description, for purposes of explanation and non-limitation, specific details are set forth, such as particular nodes, functional entities, techniques, protocols, etc. in order to provide an understanding of the described technology. It will be apparent to one skilled in the art that other embodiments may be practiced apart from the specific details described below. In other instances, detailed descriptions of well-known methods, devices, techniques, etc. are omitted so as not to obscure the description with unnecessary detail.

Sections are used in this Detailed Description solely in order to orient the reader as to the general subject matter of each section; as will be seen below, the description of many features spans multiple sections, and headings should not be read as affecting the meaning of the description included in any section.

### Overview

The techniques herein include processes for acquiring data (e.g., 3D geometry data) of real-world objects in order to, for example, perform validation testing and the like by using a generated three-dimensional virtual model. The techniques herein relate to acquiring data of sufficient fidelity in order to allow for an accurate three-dimensional model to be created that can be used in a validation process for a manufactured component (e.g., an aircraft component). The techniques herein include using three-dimensional scanning systems to acquire precise locations of the structural elements of an object and then use that information to perform geometric dimensioning and tolerancing (GD&T) on manufactured components. The techniques herein facilitate obtaining data so that the "position" (e.g., the "true position") of the physical properties of the manufactured component can be accurately represented within a virtual space. This allows for validating that the component has a desired form (e.g., within a level of engineering tolerance).

The techniques discussed herein may be particularly applicable in the manufacturing and/or validation of aircraft turbine engines and the blades thereof. Blades that are used in turbine engines may include cooling holes that facilitate using cooler air to pass over and/or through the blade. This process maintains the temperature of the blade within operational limits of the material that the blade is made out of. The holes that are used in these blades can thus play an important role in keeping the temperature of the blades lower and allowing for increased performance and/or prospering operating conditions.

It will be appreciated that while the techniques herein may be applicable to acquiring data from such blades, that the techniques herein may be used in connection with other types of manufactured parts or components.

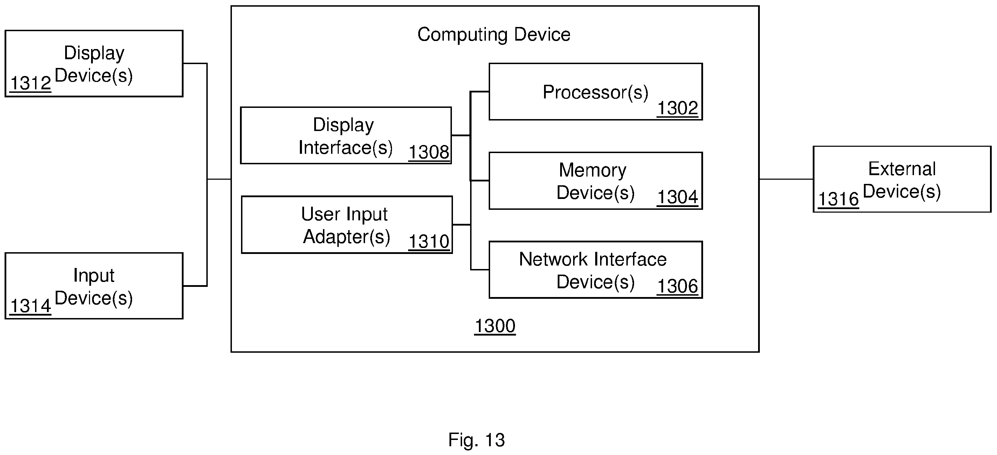

In many places in this document, software (e.g., modules, software engines, services, applications, and the like) and actions (e.g., functionality) performed by software are described. This is done for ease of description; it should be understood that, whenever it is described in this document that software performs any action, the action is in actuality performed by underlying hardware elements (such as a processor and a memory device) according to the instructions that comprise the software. Such functionality may, in some embodiments, be provided in the form of firmware and/or hardware implementations. Further details regarding this are provided below in, among other places, the description of Figure 13.

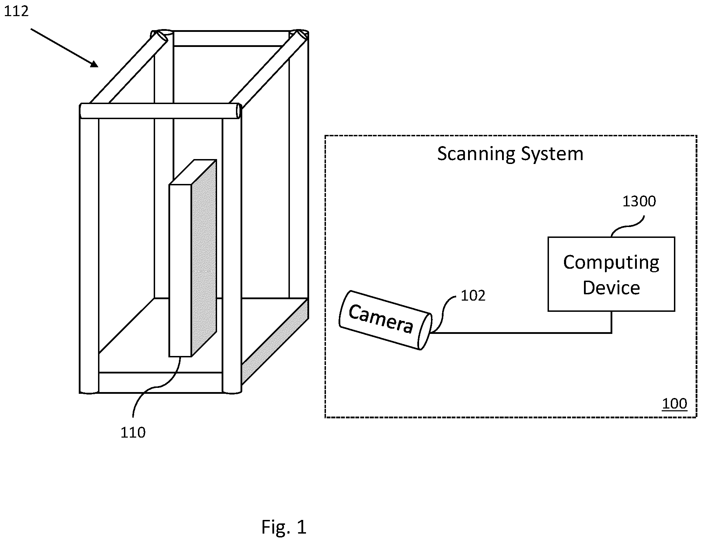

### Description Of Figure 1

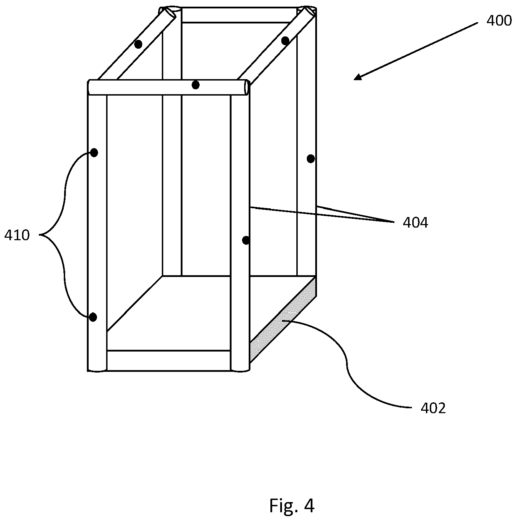

Figure 1 shows an example scanning system 100, fixture 112 (discussed in connection with Figure 4-8), and an aircraft component 110 according to certain example embodiments. The scanning system 100 includes a computing device 1300 and a scanner 102.

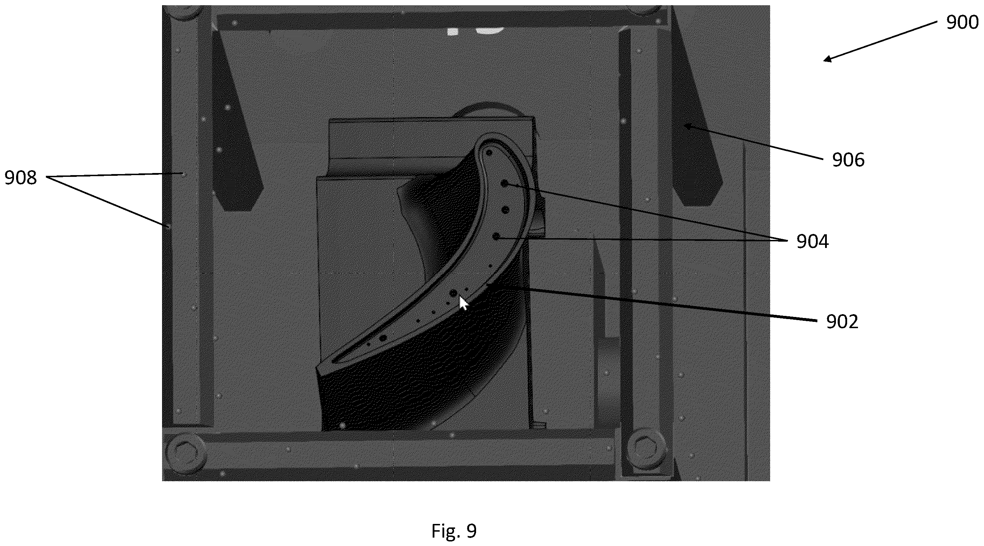

The scanning system 100 may be a 3D scanning system that includes a 3D scanning application (e.g., that executes as software on computing device 1300, such as discussed in connection with Figure 13) that includes functionality for processing received 3D data and generating a 3D mesh that can be viewed (e.g., as illustrated in Figures 9-12) by a user on a display device.

Scanner 102 may be a 3D scanning system. The scanner 102 may include a projector, a camera, and a lens system. In some examples, the scanner 102 may use blue light scanning technology in order to acquire data of the object that is being scanned. In such an example, the projector of the system is configured to emit blue light onto an object (e.g., the blade 110 and/or fixture 112), the camera and lens then acquire images of the blue light illuminated surfaces. An illustrative non-limiting example of a 3D scanning system that may be used in certain example embodiments is the ATOS ScanBox Series 4 (e.g., the ATOS ScanBox 4105, which may use the ATOS Q series sensor from Zeiss Metrology). In certain examples, the 3D scanning scanner can include CT scanning or laser scanning techniques.

An illustrative non-limiting example of a 3D scanning program is Ziess Inspect (including prior versions named "GOM Inspect") developed by GOM Metrology (also called "ZEISS Industrial Metrology"). It will be appreciated that the while certain parameters discussed herein are provided with reference to the nomenclature used by GOM Inspect, that other types of software may also be used according to certain example embodiments.

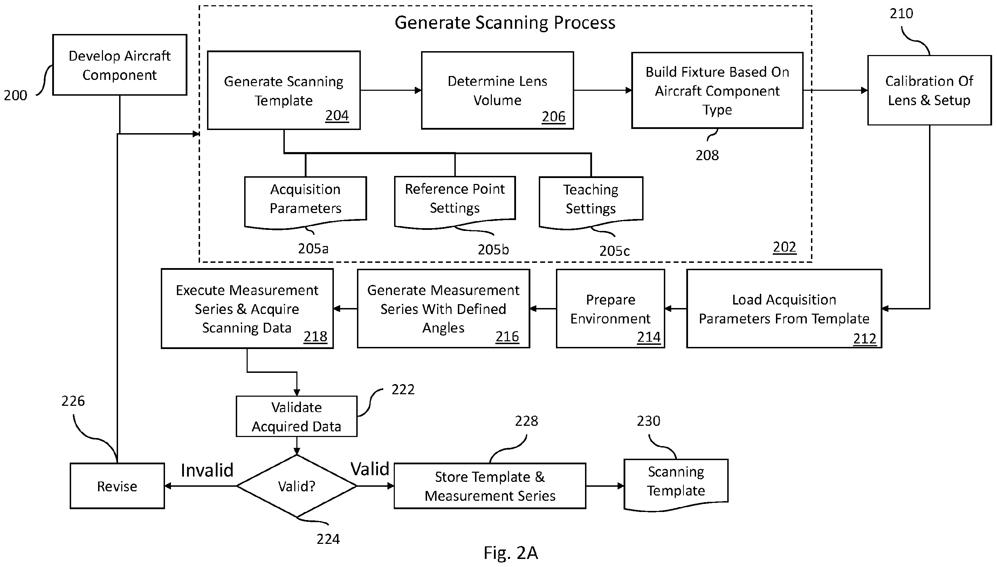

The scanning system 100 that is used to acquire 3D positional data of a given component may be configured with various parameters and properties that allow for autonomous or semi-autonomous data collection and analysis of each component for which data is being acquired. In certain examples, and as discussed in greater detail in Figure 2A, each component type may be associated with its own set of values for the multiple different parameters that are used in the collection of data from a component.

### Description Of Figure 2A

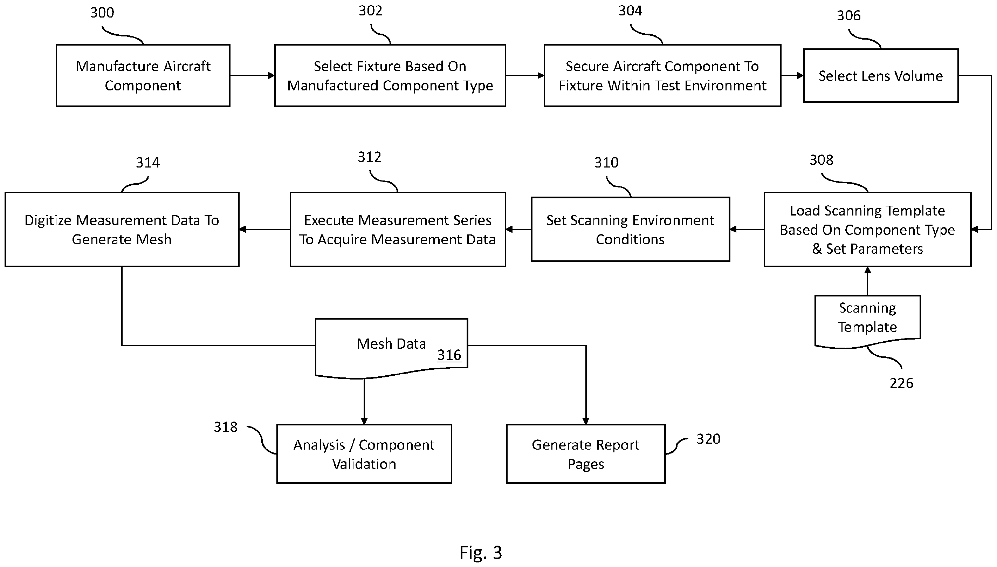

Figure 2A is a flow chart of an example process for developing a scanning process that can be used in testing / validating aircraft components (or other types of manufactured components) according to certain example embodiments. The process shown in Figure 2A may be used in connection with each different model or type of component that has been manufactured. For example, when a new type of turbine blade is being developed, the process shown in Figure 2A may be used to develop a scanning process that can then be used for each successive blade of that type that is manufactured. Using the developed scanning process (as discussed in connection with Figure 3) for each manufactured component can assist in validating that each component has been manufactured as designed (e.g., within a tolerance range).

Turning to the process shown in Figure 2A, at 200 an aircraft component (which may also be called an aircraft "part" herein) is developed and/or manufactured. In certain examples, the aircraft component may be manufactured according to a design specification. The type of aircraft component may be, for example, a blade for a jet engine turbine. It will be appreciated that different types of turbine blades may be manufactured and that the properties of such components may vary from blade type to blade type. In certain examples, a turbine blade may have cooling holes that improve the thermal performance of the blade during operation. In certain examples, a turbine blade may have diffusors. Accordingly, the properties and/or physical structures of the manufactured components can vary from between component types (or blade type to blade type). Due, in part, to the physical variations between the different types of blades (or other component types), a tailored scanning process may be developed for each blade type.

Once an aircraft component has been manufactured, then a testing process for that component type may be developed. The development of the testing process includes developing a scanning process at 202 that is designed to acquire the data that is needed to validate that a component has been manufactured as designed.

In certain example embodiments, each type of component (e.g., each different blade type or each different other aircraft or other component) has a scanning process that is developed and unique for that component type. However, in certain examples (e.g., where the differences between types of components are within a threshold or non-material to validation of a given component), all or some of the elements of a scanning process designed for one type of component may be used for another type of component. As an illustrative example, and as discussed below, a fixture that is built for one component type (at 208) may also be used for another component type.

In certain examples, a scanning process that is used for a component may include using a 3D scanning system (such as 100 from Figure 1) to acquire data of the object in question.

The development of a scanning process 202 that can be repeatedly used for each instance of a component type that is manufactured includes generating a scanning template at 204. The scanning template allows parameters associated with the acquisition of the data to be defined and then loaded each time a new scan is performed for a component (as discussed in connection with Figure 4). This allows repeatability of the scanning process in order to validate that each manufactured component complies with its designed specification.

In certain example embodiments, a scanning template may include acquisition parameters 205a, reference point settings 205b, and teaching settings 205c. Each or any of these may be configured by an engineer as part of the process shown in Figure 2A. Other parameters or settings may also be included in a scanning template, such as polygonization settings that define how the data acquired by the scanner will be used to generate a 3D mesh.

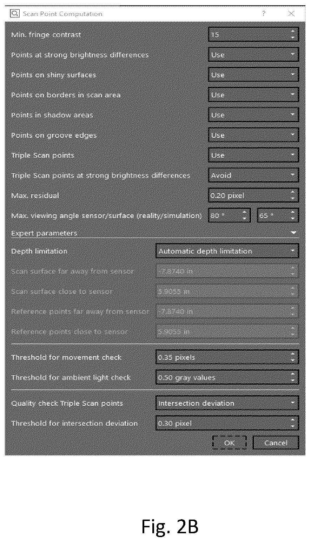

Acquisition parameters 205a include different types of parameters that control how data for each shot from a scanner is acquired. Figure 2B is dialog window from a software program that includes example acquisition parameters and example values.

An illustrative example of an acquisition parameter is an exposure time mode. The value for this parameter may be set to be, for example, a "manual" or "automatically by CAD." In certain examples, when a component includes cooling holes the exposure time mode for an acquisition parameter can be set automatically by CAD. However, if the component includes diffusors or deeper than "normal" cooling holes, a manual mode may be used that allows an engineer to interactively set the exposure time mode. Controlling the exposure time helps in capturing an optimal amount of light for clear and detailed scan data. Longer exposure times can improve the quality of scans in low-light conditions or with dark-colored objects, while shorter exposure times can be suitable for well-lit environments or bright-colored objects.

Another type of acquisition parameter may be a parameter that defines how much movement between shots for the scanner is allowed to make. In certain examples, values between 0.2 and 0.3 pixels may be used. However, in certain cases other values up to, for example, 0.6, 1, 2, 3, or up to 6 pixels may be used.

Another type of acquisition parameter is a resolution setting. Adjusting the resolution setting can allow for capturing finer details of an object's surface. Higher resolution settings can be beneficial when scanning intricate or small objects (e.g., such as cooling holes), while lower resolutions can be sufficient for larger objects or when speed is a priority.

Another type of acquisition parameter that may be used is a setting for a number of scans that can be combined or otherwise averaged. Adjusting this parameter can result in an improved signal-to-noise ratio - which can enhance the overall quality of the scan data. Averaging multiple scans can facilitate a decrease in noise and other inconsistencies in the captured data, thus resulting in a smoother and/or more accurate surface representations of the object being scanned.

The "Threshold for Movement Check" parameter shown in Figure 2B is a parameter that may be tuned depending on the lens size needed for the inspected feature. It will be appreciated that if this setting is not tuned, then the machine may account for vibrations in the cell and environment, which can cause and an inflated cycle time.

Additional parameters shown in Figure 2B include accounting for points at strong brightness differences, on shiny surfaces, on borders in a scan area, in shadow areas, on groove edges, and triple scan points. In certain example embodiments, these settings may be enabled to allow the scanner to pick up more reference points to assist in scan translation and overall mesh accuracy.

Another parameter may include the threshold for ambient light check parameter. This parameter may be tuned based on the environment in which the scanning takes place. For example, the lighting in which the object is being inspected. It will be appreciated that if this setting is not tuned, then the overall scan cycle time may be inflated.

Other acquisition parameters can be used in certain example embodiments. It will be appreciated that the parameters and values used for such parameters can vary based on, for example, the type of blade begin scanned. Different blades may have different sizes, angularity, areas to inspect, and the like. And each of these characteristics can influence what values are used for the various acquisition parameters.

Moreover, when a scanning processing is being developed it can be desirable to perform the scanning to acquire the data in an efficient manner. In other words, it is desirable to collect an amount of data that meets the required threshold to perform validation of the component. But it could be inefficient in certain examples to collect double the data or additional data as such acquisition is not needed. The collection of duplicate data can, for example, result in efficiency losses. For example, if a scanner includes multiple shots of the same point on a component, then those multiple shots may be superfluous when the 3D mesh is created.

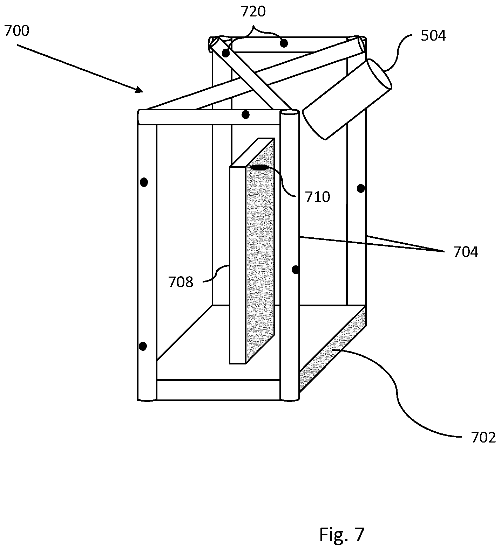

Reference point settings 205b include parameters for the positional locations of target points (e.g., 410 and 720 of Figures 4 and 7) that are set on the fixture. These reference points may be premeasured prior to the start of scanning of component. For example, just the fixture (with the reference points) may be scanned, and the results saved to a data file that may then be accessed when the component is scanned (along with the fixture). Then when a mesh of a component is to be created the data for the reference points can be used to assist in determining the locations of measured points in the scanned volume. In other words, the defined reference points can guide or otherwise assist with the creation of a mesh for a scanned component.

Teaching settings 205c include parameters such as overlap, point density, and surface type. The overlap parameter is used to determine/set the degree of overlap between adjacent scan regions. In some instances, increasing the value of the overlap parameter can be used to facilitate a more comprehensive coverage for the scan. This can assist in stitching together (e.g., seamlessly) multiple scan regions to create a complete 3D model with fewer artifacts or gaps. The point density parameter can be used to control the number of data points captured per unit area on the object's surface. Higher point densities can result in more detailed scans with finer surface features, while lower densities are suitable for larger objects or when scanning speed is a priority. The surface type parameter can be used to select an appropriate surface type of the object being scanned (e.g., matte, shiny, dark, transparent, etc.). Setting this parameter assists in optimizing the scanning parameters accordingly. This can, for example, help ensure an optimal performance and accurate results - especially when dealing with challenging surface characteristics such as reflectivity or transparency.

In certain example embodiments, one or more parameters for teaching settings 205c includes defining a minimum threshold of the percentage of data points needed to create a cylinder or fitting element within a cooling hole of a blade. In certain example embodiments this may be set to at least 50%, at least 60%, or at least 70% or more. In some examples, this value may be between 50% and 75% for this parameter. The 50% to 75% coverage for this parameter of the teaching setting refers to a recommended amount of surface coverage by the projected blue light pattern during the feature creation process. In other words, during the teaching (or calibration phase), the scanner is learning the geometry of an object or feature thereof - the target (e.g., ideal) pattern for the projected blue light is to cover approximately 50% to 75% of a given surface area (e.g., the feature in question). This coverage range can be used to ensure that enough data points are captured to accurately represent the geometry of that feature - while also avoiding excessive overlap or gaps in the scanned data. Accordingly, tuning this parameter helps to optimize the scanning process for creating a detailed and precise digital representation of the feature (and/or the object as a whole). Thus, for example, when the feature is a cooling hole, at least 50% of the surface area of the hole may be covered with/associated with the blue light projected from the scanner. This can then be used to assist in creating fitting elements to ensure that, for example, a cooling hole has been generated appropriately within the object. Using at least 50% can enable an accurate and reliable production of cylinders, ensuring that they are fit for purpose and meet the required specifications for the aircraft component.

Another aspect for developing the scanning process for a component is the determination of a lens volume that will be used for the 3D scanner. Different lenses and/or volumes may be used based on the type of component that is to be measured. For turbine blades (including those with cooling holes) the inventors determined that a 100mm lens volume, such as the CP40/MV100, provided a workable combination for acquiring the quantity and quality of data from a given blade type. Other types of lens volumes may also be used in certain examples. For example, larger lens volumes (e.g., 150mm, 170mm, or between 100mm and, for example 500mm) may be used for surface inspections (e.g., of an airfoil or the like). In other examples, a 50mm lens could be used. However, when using a 50mm volume, the results may be too inconsistent in some circumstances. In contrast, a larger lens volume, such as a 100mm may provide better results for acquiring data from the same component.

Another part of developing a scanning process is creating a fixture to hold the component that is to be scanned. Accordingly, at 208, a fixture is built / designed to hold the component during the 3D scanning process. The fixture provides a way to hold the component in place during the scanning process and also provides a structure for locating multiple different reference points. The reference can be used to assist in acquiring/mapping the 3D scanning data of the component.

In certain example embodiments, each component type has a corresponding fixture that is designed to hold that type of component during the 3D scanning process. Accordingly, if there are 10 different types of blades, then there may be 10 different types of fixtures - each having been designed with the physical requirements of the corresponding blade type. While many component types may have their own corresponding fixture, in certain example embodiments, 2 (or more) component types may share the same fixture type. This may be the case when two types of components are, for example, similar in structure.

Referring now to Figures 4-8, Figures 4 and 7 illustrate two different types of fixtures, 400 and 700, that are used to hold different designed aircraft components, 500 and 708.

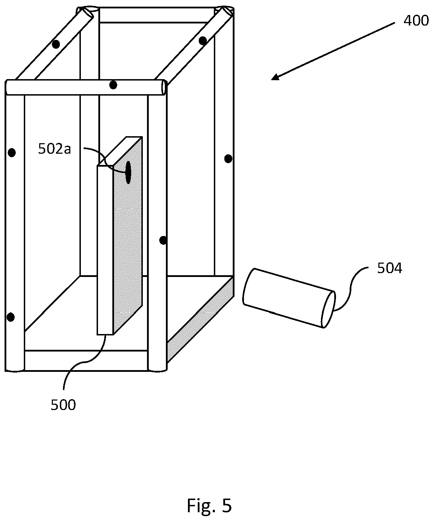

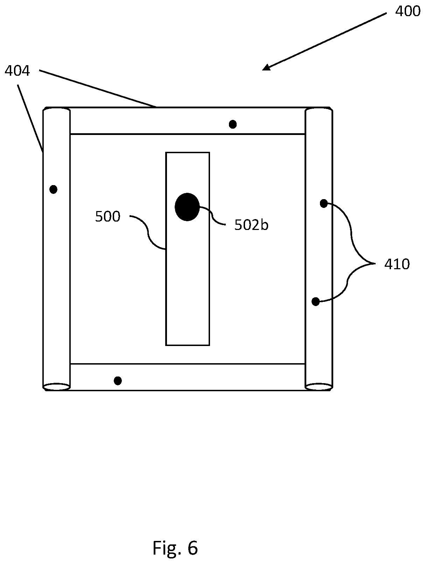

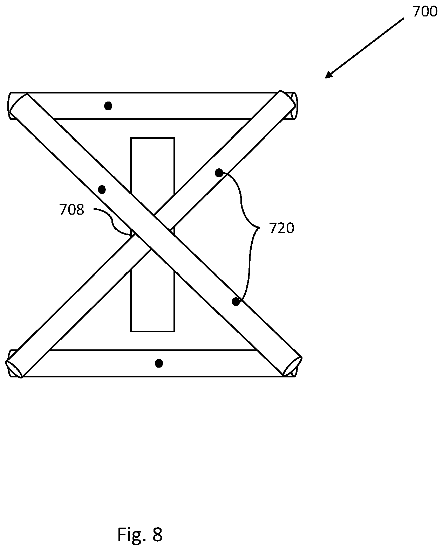

Figure 4 illustrates the fixture without a component placed within the fixture, and Figure 5 shows the fixture of Figure 4 with a component placed therein. Figure 6 is a top-down view of the fixture and component shown in Figure 5. Figure 7 illustrates another type of fixture with a different type of component placed therein. Figure 8 is a top-down view of the fixture and component shown in Figure 7.

Each fixture may include a base plate (402, 702) that is configured to be affixed (e.g., bolted or the like) to a scanning base (not shown) of a 3D scanning system that includes scanner 504 (which may be an example of scanner 102 discussed above). Each fixture may include a vice or other mechanism (not shown) to grasp or hold the component in place while the scanner 504 acquires positional data of the component.

Each fixture may also include one or more scaffolding struts (404 or 704) or other structural members that may be arranged vertically, horizontally, or otherwise. In general, the struts of a fixture may be designed to: 1) hold reference points (410, 720) that are used by the scanning system; 2) allow a camera or other scanning device (504) to acquire data from the component (500, 708) that is being held by the fixture. In other words, struts may be positioned to allow an unobstructed view of a given position on the component that is position within / on the fixture, but also be positioned so that the reference points on the struts are within the volume for which data is being acquired by the scanner.

The reference points may be located along the struts or other structural elements of the fixture and act as known reference points for determining the location of the scanned component (and the physical characteristics thereof).

The inventors determined that building different fixtures (as opposed to using a uniform fixture) for each type of aircraft component (e.g., each different turbine blade model) can be beneficial to acquiring 3D scanning data for each corresponding component type. As an illustrative example, aircraft component 500 may include cooling holes 502a and 502b. The fixture may be constructed to allow scanner 504 to be positioned so as to acquire positional data of the structure of the component within each of holes 502a and 502b. In the case of hole 502b on the "top" of the component, the fixture 400 may have a rectangular (or square) shaped top that allows scanner 504 to acquire scanning data of the top portion of the component (and cooling holes 502b located thereon).

However, a different type of design may not include cooling holes along the top of the blade and thus an opening along the top of the fixture may not be needed. An illustrative example of such a case is shown in Figure 8, which is a top view of the fixture shown in Figure 7. For fixture 700, due to the angle of the cooling hole 710 in component 708, it may be beneficial to allow the scanner 504 to move to a position that allows it to acquire data for cooling hole 710. Accordingly, the struts 704 of fixture 700 may be designed to allow for the scanner 504 to access a position in space around the component to acquire such data.

Another example of how a fixture may be arranged is that instead of the struts arranged in a rectangular shape, the struts may be arranged in a diamond like shape around the component. In certain example embodiments, the arrangement of the struts may also not be systematical.

Once the fixture and lens have been selected, then the fixture is secured to the scanning system (further details discussed below and in connection with Figure 3), and the component secured to the fixture. With the fixture and component secured, then the selected lens and the system may be calibrated and setup at 210. Such calibration may include validating that the scanning system has been set up correctly for data acquisition.

In certain example embodiments, the calibration at 210 may include performing initial validations or testing of the fixture and/or the placed reference points to ensure that data of the component that is to be acquired can be obtained. For example, if a strut from a fixture needs to be moved to ensure that a scanner can acquire data for a cooling hole from a given angle, then the fixture may need to be redesigned.

In certain example embodiments calibration may be performed using a calibration plate or target that contains known geometric features. The following is illustrative for how calibration may be performed. At a preparation step, the calibration plate is placed within the scanning area of the scanning system. The plate may be positioned securely and to cover a sufficient portion of the field of view of the scanner.

Next, at an acquisition step the system captures multiple images of the calibration plate from different angles and orientations using blue light projection. These images are taken to analyze the distortion and aberrations present in the optical system.

Next, at an analysis step, the captured images are processed by the system (e.g., software thereof) to analyze detected features on the calibration plate. By comparing the known geometric features of the calibration plate with the detected features in the images, the system can calculate the distortions present in the optical system.

At an adjustment step, based on the results of the analysis step, the system automatically adjusts the parameters of the lenses, such as focal length, distortion coefficients, and other optical properties, to minimize the detected distortions and aberrations.

At a verification step, once the adjustments are set, the system may perform additional validation checks (e.g., repeating any or all of the above steps) to ensure that the calibration has been successful. This may involve capturing additional images of the calibration plate and comparing the results with the expected geometric features.

After a successful calibration, the scanning system is now ready to perform accurate and precise 3D scanning of objects within its field of view, ensuring high-quality scan data with minimal optical distortions.

At 212, once calibration is complete, then the acquisition parameters defined at 204 may be loaded by the scanning system.

At 214, the environment in which the scanning is to take place is prepared. More specifically, the inventors determined that darkening the scanning area in which the scanning system operates can improve the quality of the data obtained by the scanning system of the component that is being measured. In certain example embodiments, the scanner may include a blue light camera that acquires data using blue light technology (e.g., that is projected onto the object being scanned). Using such a system, the inventors determined that reducing the amount of light (e.g., visible, natural or artificial, white light) within the scanning room may improve the accuracy of the data that is acquired (and thus the efficiency of the acquisition). In certain example light as used herein may include ambient light, white light, light that is visible to the camera acquiring the data (other than light projected by the projector - such as a blue light projector).

In certain example embodiments, using a dark environment can enhance scan results for objects that are being scanned. In certain example embodiments, setting up a dark environment may include the elimination (e.g., substantially so) of all visible light (e.g., white light) from the environment in which the object is being scanned. In some examples, light that is substantially removed may include any light not produced by, for example, the blue light projector of the system. In other words, blue light scanning involves projecting a structured pattern of blue light onto the object being scanned and capturing the reflected light using cameras. However, all light other than the projected blue light may be substantially removed to create the dark environment. In some examples, light may still be included in the scanning environment if that light is not visible (e.g., substantially not visible to) to the camera acquiring the data. A dark environment may thus be similar to x-ray rooms or photo development rooms that can include, for example a red-light source.

In some situations, the presence of ambient light can create reflections and/or glare on the surface of the object. These reflections and glare can interfere with the scanning process, causing inaccuracies or distortions in the resulting scan. By using a dark environment, the scanner can more accurately capture the contours and details of objects that may be "shiny" (e.g., having a reflective property) - thus leading to clearer and more precise scan results - especially in situations in which the measurements are less than, for example 100 thou (or 500 thou). Dark environments can thus help a scanner's sensors to better distinguish between the actual surface of the object and any reflections or artifacts caused by surrounding light sources (e.g., different from the blue light projector of scanner). This can also assist in improving the overall quality of the data acquired from a scan.

Using a dark environment, ambient light sources such as sunlight, room lighting, or other sources of light are either dimmed, substantially removed, or eliminated to prevent the corresponding light affecting the blue light pattern or interfering with the ability of a camera to accurately capture data. This controlled lighting environment (a dark environment) helps ensure that the blue light pattern is more clearly projected onto the surface of an object and that the cameras can accurately detect and analyze the reflected light, resulting in more precise and reliable scan results.

In certain example embodiments, the amount of light within the scanning room may be similar to that used in a dark room for developing photos. It will be appreciated that in some instances the use of blue light technology for scanning objects may not seemingly benefit from reducing the visible, ambient, natural, or artificial light within the scanning room. However, in connection with the example embodiments described herein, the inventors determined that reducing the light (e.g., visible and/or ambient light) within the scanning room provides beneficial results. This approach may thus go against conventional approaches in which blue light scanning is used within environments that are well lit and the like.

In some examples, the preparation of the environment at 214 may include raising or lowering the position of the component with respect to the position from which the scanner is acquiring the data. In some examples, the fixture may be fixed to plate that is between 100mm and 400mm thick, or between 200 and 300mm. The additional thickness of the plate may allow the scanner to acquire data more effectively from "lower" positions. For example, there may be cooling holes in the "bottom" of the blade (or near the bottom) that could otherwise be difficult for an automated 3D scanner to acquire data of. Accordingly, the fixture and the component held therein can be moved "upwards" to allow low angle shots by the scanner of the component (e.g., when a cooling hole on a blade is located on a "bottom" section of the blade).

At 216, a measurement series may be generated based on the acquisition parameters (and other parameters). More specifically, depending on the which points of the component are to be scanned, a measurement series can be manually or automatically generated. This series is used to positionally control where the scanner will be located within the space around the component to acquire the data as defined in the scanning template. The measurement series may define a series of data elements that each include: 1) the location of the scanner within real-space (e.g., x, y, z coordinates) and the orientation for the viewing direction of the scanner (e.g., a viewpoint or a view direction) so that data may be acquired for a given part of the component. In certain example embodiments, between 20 and 50 (or more) such scanning points may be determined and used as part of a measurement series. The order in which data for each point is obtained may be automatically determined so as to efficiently use the scanner and to decrease the amount of movement of the scanner in capturing the various data points. In certain example embodiments, each data element of the measurement series may be automatically or manually defined. In the case of manual input, a user may manually control the position of the scanner in order to ensure that data for a location of the component that is of interest is being properly acquired. In certain example embodiments, each angle or shot from a scanner includes at least 4 of the reference points from the fixture. In other words, the volume in which data is acquired for the scanner may be arranged to also include at least 4 reference points from the fixture. In some instances, the number of reference points may be at least 3 or at least 6 so as to properly oriented and position where the acquired data for generation of a 3D mesh.

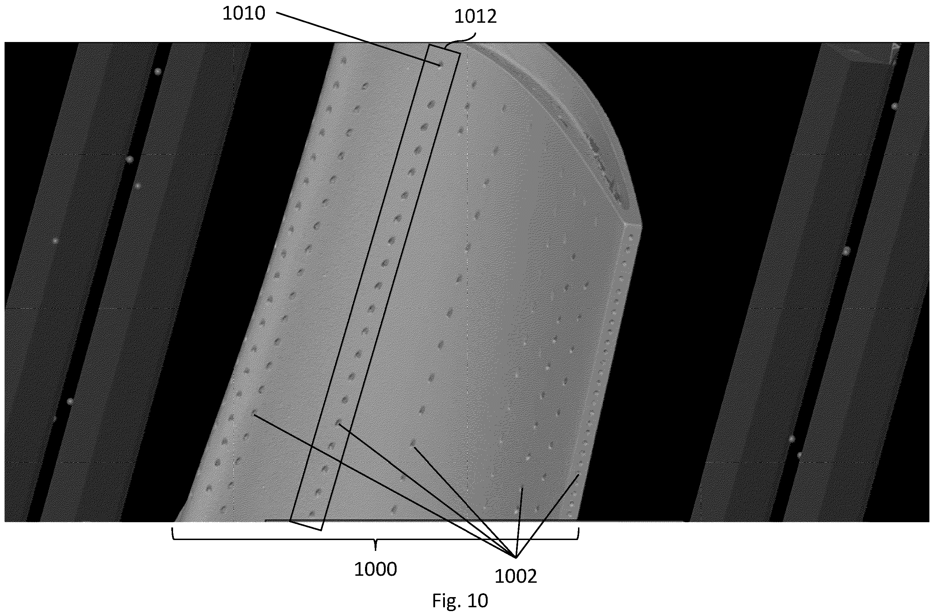

When a measurement series is generated for analyzing a component, it may not be necessary to analyze every cooling hole or other physical feature of the component in order to perform a validation for the component. As an illustrative example, consider blade 1000 shown in Figure 10. There may be up to one hundred or more holes 1002 within the blade. Acquiring data for each hole within the blade can be time consuming as the scanner may need to be moved to a different position for each shot, the data acquired and then processed. Accordingly, in certain example embodiments, a sampling technique can be used to acquire data more efficiently for the component in question.

In certain example embodiments, the sampling process may include acquiring data of the "top" and "bottom" holes in a row of holes. A benefit of this type of sampling technique is that the machine that is used to form the holes in the blade may operate in a row (with row 1012 being an example of a row of holes). In other words, a machine (e.g., a specific tool thereof) proceeds in a row and drills or otherwise forms each hole within the blade. The tool creates the first hole and then proceeds to sequentially create the holes within a row and thus the expected deviation of those holes may be relatively consistent. Accordingly, by acquiring data of the first and last holes in a row, the holes can be sampled in an efficient manner. The acquired data can be used for analyzing whether the holes within the row are valid. This sampling process can be effective because if the tool is misaligned, is bumped, or otherwise moves unexpectedly during the sequence in which the holes are formed, then an indication of such an error will show up on either the first or last hole in a row. If the first and last holes are consistent (and within design tolerance), then the intermediate holes are highly likely to be valid as well. This arrangement for setting up the measurement series to acquire data in this manner advantageously can provide for more efficient processing and validation of the component in question. For example, if there are 200 different holes in a blade (e.g., 40 each in 5 different rows), then it can be at least an order of magnitude more efficient to process the first and last holes (10 total) versus acquiring data for all 200 holes.

However, in certain instances it may be desirable to perform a complete analysis of every physical feature of a blade may be performed. This may be performed, for example, when a newly designed blade is being inspected (and production machinery is being tuned) or as part of a quality review process in which a longer and more extensive data acquisition process is performed. For this processing, data for all of the holes and/or other structural features is obtained and then analyzed. Thus, for example, the scanner is moved to appropriate positions to acquire data for each of the possibly 100+ holes within the blade. In certain example embodiments, such intensive data collection may be performed on a master blade that can be used as a template for how the blade should be manufactured. In such cases the actual tolerance of the master blade may be half of the design tolerance for the physical features (e.g., the positioning of the holes). Accordingly, for example, if the tolerance for the location of given hole is 30 thou, then the tolerance for the blade to be classified as a master blade is 15 thou. The master blade can then be used as, for example, a template or reference to create additional blades. Accordingly, the processing discussed herein can, in addition to validating blades from a production, also be used to set up and configure a production line for the creation of blades.

The acquisition of data for the cooling holes in the manner discussed herein can also be beneficial as it provides a more efficient determination of whether a given blade can operate with the required airflow design (e.g., to keep the blade cool). If the 3D data acquisition and modeling process indicates a failure of the blade (e.g., because the cooling holes are improperly positioned), then there is no need to conduct extensive airflow testing on the blade to validate a blade that is already shown to be failing.

Returning to Figure 2A, at 218, once the measurement series is determined, then the measurement series is executed by the scanning system and the data for each point in the series is captured by a scanner and stored.

At 222, the acquired data is validated. This may include generating a virtual 3D mesh of the object and then determining (automatically or manually) that all of the locations of the component for which needs to be acquired have been captured.

At 224, if the acquired data is accurate (e.g., the generated mesh is accurate), then the parameters used for measurement series, the scanning template 230, and any other aspects are stored at 228. This may include storing the created fixture, and saving which lens was used for the capturing of the 3D data.

If, however, the data acquired is determined to not be valid at 224, then any of the parameters used in the processing discussed above may be revised at 226 and the steps repeated. For example, as part of reviewing the acquired data, an engineer may determine that the structural layout of the fixture may need to be modified in order to allow the scanner to capture data of the component from another angle. In another example, an engineer may determine that additional acquisition points on the component may be needed in order to properly construct a 3D mesh of the component. In another example, an engineer may determine that a different lens may be used in order to acquire the 3D data. Accordingly, the process shown in Figure 2A may be rerun with changes as needed (a different lens, a different fixture, a change in the scanning template, etc.) in order to acquire a new dataset for the subject component.

Accordingly, the process shown in Figure 2A may be performed multiple times for a given component until the data that is acquired for that component type is validated.

In certain example embodiments, the processing shown in Figure 2A may include an additional optimization step. In other words, once an initial measurement series has been generated that retrieves all of the data that is required to perform analysis (e.g., via 216), then the measurement series (and corresponding moves of the scanner) may be optimized to, for example, remove redundant points within the measurement series. As an example, an initial movement series may have 150 different shots from a scanner (e.g., the system moves the scanner to 150 different locations). However, a more optimized measurement series that may be created may have between, for example 30 to 120 different moves that are performed by the scanner. Accordingly, the optimization process that can be performed allows for more efficient use of the scanner in acquiring the data that needs to be acquired.

### Description Of Figure 3

Figure 3 is a flow chat of an example process that may be repeatedly used for testing manufactured aircraft parts according to certain example embodiments. Once a valid process for acquiring data from a given component type has been developed as discussed in connection with Figure 2A, then the process may be deployed and used to validate each different instance of a new component that has been manufactured.

At 300, an instance of an aircraft component is manufactured. As noted herein, the type of component may be a blade for a turbine engine. Each newly manufactured instance of a type of component may be subjected to the processing shown in Figure 3 (assuming that the specific details for that type of component have been determined as discussed in connection with Figure 2A).

At 302, the fixture for the specific type of component may be selected. As noted above, each type of component may have a purpose-built fixture that is used to hold each instance of the component that is being validated. For example, multiple different types of fixtures may be developed from which one may be selected depending on the type of component that has been manufactured. The fixtures shown in Figures 4-8 provide examples of different fixture designs. In certain example embodiments there may be dozens of different possible fixtures to selected from.

At 304, once the fixture has been selected based on the type of component, then the fixture may be secured to a plate of the scanning system and the component secured to the fixture. The component may be secured to the fixture using a vice or similar apparatus. The fixture may be secured to the test environment (e.g., a plate or stand that is associated with a 3D scanning system) via bolts or the like. In certain example embodiments, different plates may be used in order to raise or lower (relatively) the position of the component with respect to where the scanner is acquiring data from. In some examples, the fixture may be fixed to plate that is between 100mm and 400mm thick, or between 200 and 300mm. The additional thickness of the plate may allow the scanner to acquire data more effectively from "lower" positions.

At 306, the type of lens that is to be used for the scanning of the given component is selected. An illustrative example of such a lens is a 100mm lens. However, other volumes of lens may also be used depending on the nature of the component and the structural features of that component.

At 308, the scanning template 226 (e.g., generated as discussed in connection with Figure 2A) is loaded based on the type of component for which scanning is to be performed. Thus, for example, if a component of type X is to be scanned, then the scanning template for "type X" components is loaded. This allows the reuse of the values for the acquisition parameters and other settings that have already been tuned to the subject component type.

At 310, the conditions of the environment in which the scanning takes place are set. In certain example embodiments, this includes reducing or eliminating visible light in which the scanning system is located. In certain examples, the environment may be similar or the same as a darkroom used for developing photos.

At 312, the measurement series (defined in the scanning template) is executed. More specifically, a 3D scanning system will automatically control a scanner to move to the indicated positions / orientations (e.g., determined via the generated measurement series) and acquire measurement data of the component from those positions and orientations. As noted above, the scanner may use blue light scanning technology in order to acquire point-based data about the surface on an object.

At 314, the acquired measurement data is used to create a three-dimensional mesh of component. The generated mesh can include thousands of different polygons that are used to represent the surface of the scanning component. Figures 9-12, discussed below, provide illustrative examples of a three-dimensional mesh that may be generated and displayed to a user on display.

At 318, the generated mesh 316 may then be used to perform analysis and validation of the component as part of GD&T process.

At 320, one or more reports may be presented to a user to indicate whether any validation errors have been identified in the component. For example, a report may indicate that: 1) all of the cooling holes are correctly placed int eh component (e.g., with a design tolerance); or 2) that one or more cooling holes have been improperly manufactured. Based on the results of the report, the component may be discarded, reinspected, or subject to a second threshold of testing (e.g., an airflow test or the like).

### Description Of Figures 9 and 10 - Example Meshes

Figure 9 is a screenshot showing a three-dimensional mesh of a blade for a turbine engine held in a fixture according to certain example embodiments. And Figure 10 is another screenshot showing a three-dimensional mesh of a blade for a turbine engine held in a fixture according to certain example embodiments.

Figure 9 includes a screenshot 900 with a three-dimensional mesh based on a scan performed for a corresponding blade 902 - e.g., subjected to the processing discussed in connection with Figures 1 and/or 3. Note that the fixture 906 in which the blade is held for the scanning process is also shown in the screenshot, and as a separate object. The fixture includes multiple different reference points 908 that are used as discussed herein. The blade includes cooling holes 904 that are represented in the generated mesh. The fixture 906 is similar to the fixture shown in the example of Figure 4 in which the top of the fixture is open to allow a scanner to acquire data from the "top" of the blade 902.

Figure 10 is another screenshot of an example 3D mesh of a blade 1000 from the side. The screenshot includes the structural elements of the fixture in which the blade was held during the scanning process. Blade 1000 includes multiple different cooling holes 1002 that are arranged in accordance with design of the blade. As noted above, these holes assist in cooling the blade during operation. Also shown in Figure 10 is a first (or last) hold 1010 in a row 1012 of holes of the blade. As discussed elsewhere herein, the row of cooling holes 1012 may have been formed sequentially using the same tool.

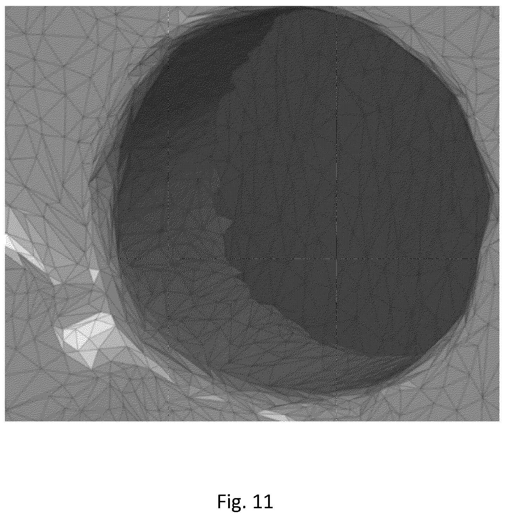

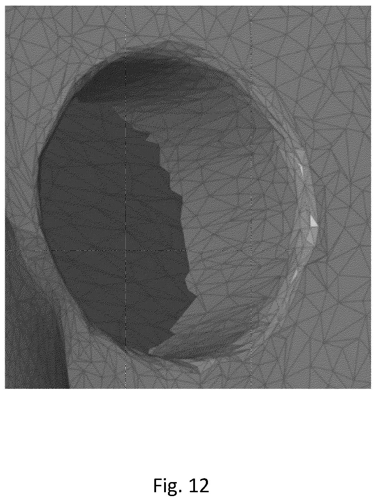

### Description Of Figures 11 and 12 - Cooling Holes

Figures 11 and 12 are close up screenshots of different views of a cooling hole in the blade shown in Figure 10 according to certain example embodiments. Note that these images include hundreds or possibly thousands of different polygons - and all within the relatively smaller area around one of the cooling holes 1002 shown in Figure 10.

### Description Of Figure 13

Figure 13 is a block diagram of an example computing device 1300 (which may also be referred to, for example, as a "computing device," "computer system," or "computing system") according to some embodiments. In some embodiments, the computing device 1300 includes one or more of the following: one or more processors 1302 (which may be referred to as "hardware processors" or individually as a "hardware processor"); one or more memory devices 1304; one or more network interface devices 1306; one or more display interfaces 1308; and one or more user input adapters 1310. Additionally, in some embodiments, the computing device 1300 is connected to or includes a display device 1312. As will explained below, these elements (e.g., the processors 1302, memory devices 1304, network interface devices 1306, display interfaces 1308, user input adapters 1310, display device 1312) are hardware devices (for example, electronic circuits or combinations of circuits) that are configured to perform various different functions for the computing device 1300. In some embodiments, these components of the computing device 1300 may be collectively referred to as computing resources (e.g., resources that are used to carry out execution of instructions and include the processors (one or more processors 1302), storage (one or more memory devices 1304), and I/O (network interface devices 1306, one or more display interfaces 1308, and one or more user input adapters 1310). In some instances, the term processing resources may be used interchangeably with the term computing resources. In some embodiments, multiple instances of computing device 1300 may arranged into a distributed computing system.

In some embodiments, each or any of the processors 1302 is or includes, for example, a single- or multi-core processor, a microprocessor (e.g., which may be referred to as a central processing unit or CPU), a digital signal processor (DSP), a microprocessor in association with a DSP core, an Application Specific Integrated Circuit (ASIC), a Field Programmable Gate Array (FPGA) circuit, or a system-on-a-chip (SOC) (e.g., an integrated circuit that includes a CPU and other hardware components such as memory, networking interfaces, and the like). And/or, in some embodiments, each or any of the processors 1302 uses an instruction set architecture such as x86 or Advanced RISC Machine (ARM).

In some embodiments, each or any of the memory devices 1304 is or includes a random access memory (RAM) (such as a Dynamic RAM (DRAM) or Static RAM (SRAM)), a flash memory (based on, e.g., NAND or NOR technology), a hard disk, a magneto-optical medium, an optical medium, cache memory, a register (e.g., that holds instructions), or other type of device that performs the volatile or non-volatile storage of data and/or instructions (e.g., software that is executed on or by processors 1302). Memory devices 1304 are examples of non- transitory computer-readable storage media.

In some embodiments, each or any of the network interface devices 1306 includes one or more circuits (such as a baseband processor and/or a wired or wireless transceiver), and implements layer one, layer two, and/or higher layers for one or more wired communications technologies (such as Ethernet (IEEE 802.3)) and/or wireless communications technologies (such as Bluetooth, WiFi (IEEE 802.11), GSM, CDMA2000, UMTS, LTE, LTE-Advanced (LTE-A), LTE Pro, Fifth Generation New Radio (5GNR) and/or other short-range, mid-range, and/or long-range wireless communications technologies). Transceivers may comprise circuitry for a transmitter and a receiver. The transmitter and receiver may share a common housing and may share some or all of the circuitry in the housing to perform transmission and reception. In some embodiments, the transmitter and receiver of a transceiver may not share any common circuitry and/or may be in the same or separate housings.

In some embodiments, data is communicated over an electronic data network. An electronic data network includes implementations where data is communicated from one computer process space to computer process space and thus may include, for example, interprocess communication, pipes, sockets, and communication that occurs via direct cable, cross-connect cables, fiber channel, wired and wireless networks, and the like. In certain examples, network interface devices 1306 may include ports or other connections that enable such connections to be made and communicate data electronically among the various components of a distributed computing system.

In some embodiments, each or any of the display interfaces 1308 is or includes one or more circuits that receive data from the processors 1302, generate (e.g., via a discrete GPU, an integrated GPU, a CPU executing graphical processing, or the like) corresponding image data based on the received data, and/or output (e.g., a High-Definition Multimedia Interface (HDMI), a DisplayPort Interface, a Video Graphics Array (VGA) interface, a Digital Video Interface (DVI), or the like), the generated image data to the display device 1312, which displays the image data. Alternatively, or additionally, in some embodiments, each or any of the display interfaces 1308 is or includes, for example, a video card, video adapter, or graphics processing unit (GPU).

In some embodiments, each or any of the user input adapters 1310 is or includes one or more circuits that receive and process user input data from one or more user input devices (not shown in Figure 13) that are included in, attached to, or otherwise in communication with the computing device 1300, and that output data based on the received input data to the processors 1302. Alternatively, or additionally, in some embodiments each or any of the user input adapters 1310 is or includes, for example, a PS/2 interface, a USB interface, a touchscreen controller, or the like; and/or the user input adapters 1310 facilitates input from user input devices (not shown in Figure 13) such as, for example, a keyboard, mouse, trackpad, touchscreen, etc.

In some embodiments, the display device 1312 may be a Liquid Crystal Display (LCD) display, Light Emitting Diode (LED) display, or other type of display device. In embodiments where the display device 1312 is a component of the computing device 1300 (e.g., the computing device and the display device are included in a unified housing), the display device 1312 may be a touchscreen display or non-touchscreen display. In embodiments where the display device 1312 is connected to the computing device 1300 (e.g., is external to the computing device 1300 and communicates with the computing device 1300 via a wire and/or via wireless communication technology), the display device 1312 is, for example, an external monitor, projector, television, display screen, etc.

In various embodiments, the computing device 1300 includes one, or two, or three, four, or more of each or any of the above-mentioned elements (e.g., the processors 1302, memory devices 1304, network interface devices 1306, display interfaces 1308, and user input adapters 1310). Alternatively, or additionally, in some embodiments, the computing device 1300 includes one or more of: a processing system that includes the processors 1302; a memory or storage system that includes the memory devices 1304; and a network interface system that includes the network interface devices 1306. Alternatively, or additionally, in some embodiments, the computing device 1300 includes a system-on-a-chip (SoC) or multiple SoCs, and each or any of the above-mentioned elements (or various combinations or subsets thereof) is included in the single SoC or distributed across the multiple SoCs in various combinations. For example, the single SoC (or the multiple SoCs) may include the processors 1302 and the network interface devices 1306; or the single SoC (or the multiple SoCs) may include the processors 1302, the network interface devices 1306, and the memory devices 1304; and so on. The computing device 1300 may be arranged in some embodiments such that: the processors 1302 include a multi or single-core processor; the network interface devices 1306 include a first network interface device (which implements, for example, WiFi, Bluetooth, NFC, etc.) and a second network interface device that implements one or more cellular communication technologies (e.g., 3G, 4G LTE, CDMA, etc.); the memory devices 1304 include RAM, flash memory, or a hard disk. As another example, the computing device 1300 may be arranged such that: the processors 1302 include two, three, four, five, or more multi-core processors; the network interface devices 1306 include a first network interface device that implements Ethernet and a second network interface device that implements WiFi and/or Bluetooth; and the memory devices 1304 include a RAM and a flash memory or hard disk.

### Selected Terminology

The elements described in this document include actions, features, components, items, attributes, and other terms. Whenever it is described in this document that a given element is present in "some embodiments," "various embodiments," "certain embodiments," "certain example embodiments, "some example embodiments," "an exemplary embodiment," "an example," "an instance," "an example instance," or whenever any other similar language is used, it should be understood that the given element is present in at least one embodiment, though is not necessarily present in all embodiments. Consistent with the foregoing, whenever it is described in this document that an action "may," "can," or "could" be performed, that a feature, element, or component "may," "can," or "could" be included in or is applicable to a given context, that a given item "may," "can," or "could" possess a given attribute, or whenever any similar phrase involving the term "may," "can," or "could" is used, it should be understood that the given action, feature, element, component, attribute, etc. is present in at least one embodiment, though is not necessarily present in all embodiments.

Terms and phrases used in this document, and variations thereof, unless otherwise expressly stated, should be construed as open-ended rather than limiting. As examples of the foregoing: "and/or" includes any and all combinations of one or more of the associated listed items (e.g., a and/or b means a, b, or a and b); the singular forms "a", "an", and "the" should be read as meaning "at least one," "one or more," or the like; the term "example", which may be used interchangeably with the term embodiment, is used to provide examples of the subject matter under discussion, not an exhaustive or limiting list thereof; the terms "comprise" and "include" (and other conjugations and other variations thereof) specify the presence of the associated listed elements but do not preclude the presence or addition of one or more other elements; and if an element is described as "optional," such description should not be understood to indicate that other elements, not so described, are required.

As used herein, the term "non-transitory computer-readable storage medium" includes a register, a cache memory, a ROM, a semiconductor memory device (such as DRAM, S-RAM, or other RAM), a magnetic medium such as a flash memory, a hard disk, a magneto-optical medium, an optical medium such as a CD-ROM, a DVD, or Blu-Ray Disc, or other types of volatile or non-volatile storage devices for non-transitory electronic data storage. The term "non-transitory computer-readable storage medium" does not include a transitory, propagating electromagnetic signal.

The claims are not intended to invoke means-plus-function construction/ interpretation unless they expressly use the phrase "means for" or "step for." Claim elements intended to be construed/interpreted as means-plus-function language, if any, will expressly manifest that intention by reciting the phrase "means for" or "step for"; the foregoing applies to claim elements in all types of claims (method claims, apparatus claims, or claims of other types) and, for the avoidance of doubt, also applies to claim elements that are nested within method claims. Consistent with the preceding sentence, no claim element (in any claim of any type) should be construed/interpreted using means plus function construction/interpretation unless the claim element is expressly recited using the phrase "means for" or "step for."

Whenever it is stated herein that a hardware element (e.g., a processor, a network interface, a display interface, a user input adapter, a memory device, or other hardware element), or combination of hardware elements, is "configured to" perform some action, it should be understood that such language specifies a physical state of configuration of the hardware element(s) and not mere intended use or capability of the hardware element(s). The physical state of configuration of the hardware elements(s) fundamentally ties the action(s) recited following the "configured to" phrase to the physical characteristics of the hardware element(s) recited before the "configured to" phrase. In some embodiments, the physical state of configuration of the hardware elements may be realized as an application specific integrated circuit (ASIC) that includes one or more electronic circuits arranged to perform the action, or a field programmable gate array (FPGA) that includes programmable electronic logic circuits that are arranged in series or parallel to perform the action in accordance with one or more instructions (e.g., via a configuration file for the FPGA). In some embodiments, the physical state of configuration of the hardware element may be specified through storing (e.g., in a memory device) program code (e.g., instructions in the form of firmware, software, etc.) that, when executed by a hardware processor, causes the hardware elements (e.g., by configuration of registers, memory, etc.) to perform the actions in accordance with the program code.

A hardware element (or elements) can be understood to be configured to perform an action even when the specified hardware element(s) is/are not currently performing the action or is not operational (e.g., is not on, powered, being used, or the like). Consistent with the preceding, the phrase "configured to" in claims should not be construed/interpreted, in any claim type (method claims, apparatus claims, or claims of other types), as being a means plus function; this includes claim elements (such as hardware elements) that are nested in method claims.

### Additional Applications of Described Subject Matter

While the techniques described above are discussed in the context of turbine blades and the like. The techniques for acquiring 3D data can be applied to other types of components - including components of a jet engine or other aircraft components.

Although process steps, algorithms or the like, including without limitation with reference to Figures 1 and 3, may be described or claimed in a particular sequential order, such processes may be configured to work in different orders. In other words, any sequence or order of steps that may be explicitly described or claimed in this document does not necessarily indicate a requirement that the steps be performed in that order; rather, the steps of processes described herein may be performed in any order possible. Further, some steps may be performed simultaneously (or in parallel) despite being described or implied as occurring non-simultaneously (e.g., because one step is described after the other step). Moreover, the illustration of a process by its depiction in a drawing does not imply that the illustrated process is exclusive of other variations and modifications thereto, does not imply that the illustrated process or any of its steps are necessary, and does not imply that the illustrated process is preferred.

Although various embodiments have been shown and described in detail, the claims are not limited to any particular embodiment or example. None of the above description should be read as implying that any particular element, step, range, or function is essential. All structural and functional equivalents to the elements of the above-described embodiments that are known to those of ordinary skill in the art are expressly incorporated herein by reference and are intended to be encompassed. Moreover, it is not necessary for a device or method to address each and every problem sought to be solved by the present invention, for it to be encompassed by the invention. No embodiment, feature, element, component, or step in this document is intended to be dedicated to the public.

## Claims

1. A method for developing a scanning process for acquiring three-dimensional data of blades for use in jet engine turbines, each of the blades including a plurality of cooling holes, the method comprising:
building a fixture for a blade based on a type of design for the blade, wherein the structure of the fixture is based, at least in part, on position and/or angularity of at least some of the cooling holes in the blade;
locating a plurality of reference points on the fixture;
generating a scanning template that includes values for a plurality of parameters;
securing the blade to the fixture;
generating a measurement series that includes a plurality of data values, wherein each of the plurality of data values includes: 1) position data for positioning a scanner, and 2) orientation data for orienting the scanner;
automatically controlling, based on the scanning template, the scanner to acquire 3D scan data of the blade by executing the generated measurement series; and
validating the acquired 3D scan data.

2. The method of claim 1, wherein the scanner includes a camera, projector, and lens, wherein the projector is configured to project blue light onto the blade, wherein the camera is configured to acquire the 3D data based on the blue light illuminated surface of the blade within a volume defined by the lens of the scanner.

3. The method of claim 2, wherein the lens defines a volume of about 100mm in depth.

4. The method of any preceding claim, further comprising:
for a row of sequentially formed cooling holes within the blade:
acquiring 3D position data for a first hole in the row, and
acquiring 3D position data for a last hole in the row, wherein the generated measurement series does not include a data value to acquire 3D positional data from holes between the first and last hole in the row.

5. The method of any preceding claim, further comprising:
optimizing a first measurement series by removing at least some of the plurality of data values of the first measurement series to thereby create the measurement series.

6. A method of acquiring three-dimensional data of blades for use in jet engine turbines, each of the blades including a plurality of cooling holes, the method comprising:
selecting, from among a plurality of differently structured fixtures, a fixture for a blade based on a type of design for the blade, wherein the structure of the fixture is based, at least in part, on position and/or angularity of at least some of the cooling holes in the blade;
loading, based on type of design for the blade, a scanning template that includes values for a plurality of parameters;
securing the blade to the fixture;
loading, from a data file, a measurement series that includes a plurality of data values, wherein each of the plurality of data values includes: 1) position data for positioning a scanner, and 2) orientation data for orienting the scanner;
automatically controlling, based on the scanning template, the scanner to acquire 3D scan data of the blade by executing the generated measurement series;
automatically performing a validation process to determine, based on the 3D scan data, that at least one of the plurality of cooling holes is within a corresponding manufacturing tolerance.

7. The method of any preceding claim, further comprising:
automatically determining, as part of the validation process and based on the 3D scan data, that at least one of the plurality of cooling holes is outside of a corresponding manufacturing tolerance.

8. The method of any preceding claim, further comprising:
darkening an environment in which the scanner is used to acquire the 3D scan data, for example darkening the environment to substantially remove visible white light from the environment prior to the scanner acquiring data.

9. The method of any preceding claim, wherein the measurement series includes a first data value and a second data value,
wherein the first data value includes position and orientation data to acquire 3D position data associated with a first hole in a row of holes formed in the blade,
wherein the second data value includes position and orientation data to acquire 3D position data associated with a last hole in the row of holes formed in the blade,
wherein the plurality of data values included in the measurement series does not include a data value to acquire 3D positional data from holes between the first and last hole in the row of holes formed in the blade.

10. The method of any preceding claim, wherein each image that is acquired by and/or that is used by the scanner to acquire 3D scan data includes at least four of the plurality of reference points that are positioned on the fixture.

11. The method of any preceding claim, wherein at least one of the plurality of parameters is a minimum threshold parameter that is for a percentage of data points within a cooling hole that is needed to create a fitting element (e.g. a cylindrical fitting element), wherein a value for the minimum threshold parameter is set to be at least 50%.

12. A system for acquiring positional data of different types of blades that are used in jet engine turbines, with each of the blades including a plurality of cooling holes, the system comprising:
a scanner that includes a projector, a camera, and a lens; and
a computer system that includes at least one hardware processor that is coupled to the scanner, the computer system configured to perform operations comprising:
loading, based on a type of design for a blade that is to be scanned, a scanning template that includes values for a plurality of parameters, wherein the scanning template includes parameters for a plurality of reference points that are associated with a first fixture designed for the type of blade to be scanned, the first fixture being among a plurality of different fixtures that are each associated with a different type of blade for which positional data can be obtained by the system;
loading, from a data file, a measurement series that includes a plurality of data values, wherein each of the plurality of data values includes: 1) position data for positioning the scanner, and 2) orientation data for orienting the scanner,
automatically controlling, based on the scanning template, the scanner to acquire 3D scan data of the blade by executing the generated measurement series, and
automatically performing a validation process to determine, based on the 3D scan data, that at least one of the plurality of cooling holes is within a corresponding manufacturing tolerance.

13. The system of claim 12, further comprising:
the plurality of different fixtures, with each of the plurality of different fixtures having different structural characteristics that are based on physical characteristics of a corresponding type of blade.

14. The system of claim 12 or 13, wherein at least one of the plurality of parameters is a minimum threshold parameter that is for a percentage of data points within a cooling hole that is needed to create a cylindrical fitting element, wherein a value for the minimum threshold parameter is set to be at least 50%.

15. The system of any of claims 12 to 14, wherein the measurement series includes a first data value and a second data value,
wherein the first data value includes position and orientation data to acquire 3D position data associated with a first hole in a row of holes formed in the blade,
wherein the second data value includes position and orientation data to acquire 3D position data associated with a last hole in the row of holes formed in the blade,
wherein the plurality of data values included in the measurement series does not include a data value to acquire 3D positional data from holes between the first and last hole in the row of holes formed in the blade.

16. The system of any of claims 12 to 15, wherein the projector is configured to project blue light onto a surface of the blade that is to be scanned.
